# EUROPEAN PATENT APPLICATION

(11) **EP 4 715 858 A1**
(43) Date of publication of application: **25.03.2026**
(21) Application number: 24201464.5
(22) Date of filing: 19.09.2024
(51) Int. Cl.: H01H 9/52, H01H 33/662, H01H 1/62, H01H 33/66

(54) **CIRCUIT BREAKER**

(71) Applicant: ABB SCHWEIZ AG, 5400 Baden (CH)
(72) Inventor: JANSSEN, Johannes, 44577 Castrop-Rauxel (DE); MASMEIER, Philipp, 61231 Bad Nauheim (DE); BAIER, Oliver, 40489 Düsseldorf (DE)
(74) Representative: Maiwald GmbH

(57) **Abstract**

The present invention relates to a circuit breaker, comprising:
- an upper terminal (1);
- a lower terminal (2);
- a switching element (3);
- an insulation housing (6);
- a heat collector (7); and
- a heatsink (8);

wherein the upper terminal is electrically connected to a fixed contact of the switching element;
wherein the lower terminal is electrically connected to a moveable contact of the switching element;
wherein the insulation housing surrounds at least part of the upper terminal, at least part of the lower terminal, at least part of the switching element;
wherein the heat collector is at least partially embedded within the insulation housing, wherein the heat collector is separated from the at least part of the upper terminal, the at least part of the lower terminal, and the at least part of the switching element by material of the insulation housing;
wherein at least a part of a surface of the heat collector facing outwards from the circuit breaker is not covered by material of the insulation housing; and
wherein the heatsink is connected to the part of the surface of the heat collector facing outwards from the circuit breaker.

## Description

### FIELD OF THE INVENTION

The present invention relates to circuit breakers, for a switchgear, such as a low voltage or medium voltage circuit switchgear, methods of manufacturing such circuit breakers, and to switchgear having such circuit breakers.

### BACKGROUND OF THE INVENTION

Switchgear, such as Gas Insulated Switchgear (GIS), generally have several compartments, such as a circuit breaker compartment, cable connection compartment, one or more busbar compartments, and other component compartments.

Heat is generated in these compartments due to joule heating as current flows through conductors, and this heat must be extracted.

The main circuit of a medium voltage circuit breaker contains sections of high temperature due to power losses of the nominal current. In high current applications, heatsinks are used to dissipate the power losses to the environment.

Heatsinks are cooled as air flows into them, is heated, and flows out thereby extracting heat from the heatsink and cooling the part of the circuit breaker to which the heatsink is thermally connected.

The heatsinks are raised to high potential along with other parts of the circuit breaker, and need to be spaced appropriately from components of the switchgear that are for example are at earth potential, and/or have specialyl designed vanes/fins and/or special coatings to mitigate electrical breakdown.

These requirments lead at addional costs and to increased size requirments internally within switchgear..

There is a need to improve this situation.

### SUMMARY OF THE INVENTION

Therefore, it would be advantageous to provide an improved way of cooling a circuit breaker of a switchgear.

The object of the present invention is solved with the subject matter of the independent claims, wherein further embodiments are incorporated in the dependent claims.

In a first aspect, there is provided a circuit breaker, comprising:
- an upper terminal;
- a lower terminal;
- a switching element;
- an insulation housing;
- a heat collector; and
- a heatsink.

The upper terminal is electrically connected to a fixed contact of the switching element. The lower terminal is electrically connected to a moveable contact of the switching element. The insulation housing surrounds at least part of the upper terminal, at least part of the lower terminal, at least part of the switching element. The heat collector is at least partially embedded within the insulation housing. The heat collector is separated from the at least part of the upper terminal, the at least part of the lower terminal, and the at least part of the switching element by material of the insulation housing. At least a part of a surface of the heat collector facing outwards from the circuit breaker is not covered by material of the insulation housing. The heatsink is connected to the part of the surface of the heat collector facing outwards from the circuit breaker.

Thus, the heat collector, to which a heat sink is connected, is casted or molded into a an electrically insulating plastic or resin insulation housing, and is not connected to any parts of the circuit breaker that operate at high voltage. The heat collector has a surface that is in effect outside the insulation hosing to which a heat sink is connected and heat is effectively extracted from the circuit breaker. As the heat collector and heatsink are not raised to high voltages, but can remain at earth potential, the heatsink can be positioned relatively close to surfaces of a switchgear at earth potential without risk of electrical breakdown. This leads to space savings and less restrictive design requirments for the heatsink that would otherwise need to have specially designed fins/vanes to mitigate breakdown.

In an example, the switching element is a vacuum interrupter.

In an example, the heatsink comprises a plurality of fins or vanes.

In an example, the circuit breaker comprises a drive connection, and the drive connection is mechanically connected to the moveable contact of the switching element.

In an example, the insulation housing surrounds at least part of the drive connection.

In an example, the heat collector is separated from at least part of the drive connection by material of the insulation housing.

In an example, the heat collector and heatsink are electrically insulated from the upper terminal, the lower terminal, and the switching element.

In an example, the heat collector and heatsink are electrically insulated from the drive connection.

In an example, the heat collector and heatsink are configured to be held at earth potential.

In an example, the heat collector and heatsink are configured to be held at earth potential when at least one of the upper terminal, and the lower terminal, the switching element.

In an example, the heat collector and heatsink are configured to be held at earth potential when the drive connection is held at a high voltage.

In an example, the heat collector and heatsink comprise a thermally conductive material.

In an example, the heat collector comprises aluminium and/or copper.

In an example, the heatsink comprises aluminium and/or copper.

In an example, the heat collector is adjacent to the lower terminal.

In an example, the material of the insulation housing has a high thermal conductivity.

In a second aspect, there is provided a circuit breaker, comprising:
- an upper terminal;
- a lower terminal;
- a switching element;
- an insulation housing; and
- a heatsink.

The upper terminal is electrically connected to a fixed contact of the switching element. The lower terminal is electrically connected to a moveable contact of the switching element. The insulation housing surrounds at least part of the upper terminal, at least part of the lower terminal, and at least part of the switching element. A first part of the heatsink is embedded within the insulation housing. The first part of the heatsink is separated from the at least part of the upper terminal, the at least part of the lower terminal, and the at least part of the switching element by material of the insulation housing. A second part of the heatsink extends outwards from the circuit breaker and is not covered by material of the insulation housing.

Thus, a first part of the heatsink is casted or molded into a an electrically insulating plastic or resin insulation housing, and is not connected to any parts of the circuit breaker that operate at high voltage. The heatsink has a second part that extends from the first part and that sits outside the insulation hosing and heat is effectively extracted from the circuit breaker. As the heatsink is not raised to high voltages, but can remain at earth potential, the heatsink can be positioned relatively close to surfaces of s switchgear at earth potential without risk of electrical breakdown. This leads to space savings and less restrictive design requirments for the heatsink that would otherwise need to have specially designed fins/vanes to mitigate breakdown.

In an example, the switching element is a vacuum interrupter.

In an example, the second part of the heatsink comprises a plurality of fins or vanes.

In an example, the circuit breaker comprises a drive connection, and the drive connection is mechanically connected to the moveable contact of the switching element.

In an example, the insulation housing surrounds at least part of the drive connection.

In an example, the heat collector is separated from at least part of the drive connection by material of the insulation housing.

In an example, the heatsink is electrically insulated from the upper terminal, the lower terminal, and the switching element.

In an example, the heatsink is electrically insulated from the drive connection.

In an example, the heatsink is configured to be held at earth potential.

In an example, the heatsink is configured to be held at earth potential when at least one of the upper terminal, the lower terminal, and the switching element are held at a high voltage.

In an example, the heatsink is configured to be held at earth potential when the drive connection is held at a high voltage.

In an example, the heatsink comprises a thermally conductive material.

In an example, the heatsink comprises aluminium and/or copper.

In an example, the heatsink is adjacent to the lower terminal.

In an example, the material of the insulation housing has a high thermal conductivity.

In a third aspect, there is provided a method of manufacturing a circuit breaker, comprising:
- assembling an upper terminal, a lower terminal, and a switching element, wherein the upper terminal is electrically connected to a fixed contact of the switching element, and wherein the lower terminal is electrically connected to a moveable contact of the switching element;
- molding at least part of the upper terminal, at least part of the lower terminal, at least part of the switching element, and a heat collector within an insulation housing, such that the heat collector is at least partially embedded within the insulation housing, wherein the heat collector is separated from the at least part of the upper terminal, the at least part of the lower terminal, and the at least part of the switching element by material of the insulation housing, and wherein at least a part of a surface of the heat collector facing outwards from the circuit breaker is not covered by material of the insulation housing; and
- connecting a heatsink to the part of the surface of the heat collector facing outwards from the circuit breaker.

In an example, the switching element is a vacuum interrupter.

In an example, the method comprises mechanically connecting a drive connection to the moveable contact of the switching element

In an example, the heatsink comprises a plurality of fins or vanes.

In an example, the heat collector and heatsink are electrically insulated from the upper terminal, the lower terminal, the switching element.

In an example, the insulation housing surrounds at least part of the *drive connection.*

In an example, the heat collector is separated from at least part of the drive connection by material of the insulation housing.

In an example, the heat collector and heatsink are electrically insulated from the drive connection.

In an example, the heat collector and heatsink are configured to be held at earth potential.

In an example, the heat collector and heatsink are configured to be held at earth potential when at least one of the upper terminal, the lower terminal, and the switching element are held at a high voltage.

In an example, the heat collector and heatsink are configured to be held at earth potential when the drive connection is held at a high voltage.

In an example, the heat collector and heatsink comprise a thermally conductive material.

In an example, the heat collector comprises aluminium and/or copper.

In an example, the heatsink comprises aluminium and/or copper.

In an example, the heat collector is adjacent to the lower terminal.

In an example, the material of the insulation housing has a high thermal conductivity.

In a fourth aspect, there is provided a method of manufacturing a circuit breaker, comprising:
- assembling an upper terminal, a lower terminal, and a switching element, wherein the upper terminal is electrically connected to a fixed contact of the switching element, and wherein the lower terminal is electrically connected to a moveable contact of the switching element; and
- molding at least part of the upper terminal, at least part of the lower terminal, at least part of the switching element, and a heatsink within an insulation housing, such that a first part of the heatsink is embedded within the insulation housing, wherein the first part of the heatsink is separated from the at least part of the upper terminal, the at least part of the lower terminal, and the at least part of the switching element by material of the insulation housing, and wherein a second part of the heatsink extends outwards from the circuit breaker and is not covered by material of the insulation housing.

In an example, the switching element is a vacuum interrupter.

In an example, the method comprises mechanically connecting a drive connection to the moveable contact of the switching element

In an example, the second part of the heatsink comprises a plurality of fins or vanes.

In an example, the heatsink is electrically insulated from the upper terminal, the lower terminal, the switching element.

In an example, the insulation housing surrounds at least part of the drive connection.

In an example, the heatsink is separated from at least part of the drive connection by material of the insulation housing.

In an example, the heatsink is electrically insulated from the drive connection.

In an example, the heatsink is configured to be held at earth potential.

In an example, the heatsink is configured to be held at earth potential when at least one of the upper terminal, the lower terminal, and the switching element are held at a high voltage.

In an example, the heatsink is configured to be held at earth potential when the drive connection is held at a high voltage.

In an example, the heatsink comprises a thermally conductive material.

In an example, the heatsink comprises aluminium and/or copper.

In an example, the heatsink is adjacent to the lower terminal.

In an example, the material of the insulation housing has a high thermal conductivity.

In a fifth aspect, there is provided a switchgear comprising a circuit breaker according to the fist aspect and/or a circuit breaker according to the second aspect.

### BRIEF DESCRIPTION OF THE DRAWINGS

Exemplary embodiments will be described in the following with reference to the following drawing:
Fig. 1 shows an example of a circuit breaker according to an embodiment of the invention; and
Fig. 2 shows an example of a circuit breaker according to an embodiment of the invention.

### DETAILED DESCRIPTION OF EMBODIMENTS

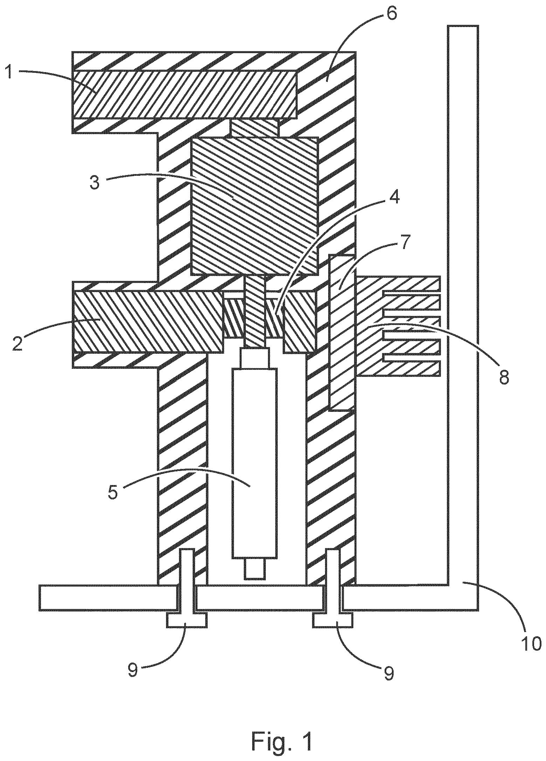

Figs. 1-2 relate to the new development for cooling a circuit breaker.

An exemplar circuit breaker comprises:
- an upper terminal 1;
- a lower terminal 2;
- a switching element 3;
- an insulation housing 6;
- a heat collector 7; and
- a heatsink 8.

The upper terminal is electrically connected to a fixed contact of the switching element. The lower terminal is electrically connected to a moveable contact of the switching element. The insulation housing surrounds at least part of the upper terminal, at least part of the lower terminal, at least part of the switching element. The heat collector is at least partially embedded within the insulation housing. The heat collector is separated from the at least part of the upper terminal, the at least part of the lower terminal, and the at least part of the switching element by material of the insulation housing. At least a part of a surface of the heat collector facing outwards from the circuit breaker is not covered by material of the insulation housing. The heatsink is connected to the part of the surface of the heat collector facing outwards from the circuit breaker.

Thus, the heat collector, to which a heat sink is connected, is casted or molded into a an electrically insulating plastic or resin insulation housing, and is not connected to any parts of the circuit breaker that operate at high voltage. The heat collector has a surface that is in effect outside the insulation hosing to which a heat sink is connected and heat is effectively extracted from the circuit breaker. As the heat collector and heatsink are not raised to high voltages, but can remain at earth potential, the heatsink can be positioned relatively close to surfaces of s switchgear at earth potential without risk of electrical breakdown. This leads to space savings and less restrictive design requirments for the heatsink that would otherwise need to have specially designed fins/vanes to mitigate breakdown.

In an example, the switching element is a vacuum interrupter.

In an example, the heatsink comprises a plurality of fins or vanes.

In an example, the circuit breaker comprises a drive connection 5, and the drive connection is mechanically connected to the moveable contact of the switching element.

In an example, the insulation housing surrounds at least part of the drive connection.

In an example, the heat collector is separated from at least part of the drive connection by material of the insulation housing.

In an example, the heat collector and heatsink are electrically insulated from the upper terminal, the lower terminal, and the switching element.

In an example, the heat collector and heatsink are electrically insulated from the drive connection.

In an example, the heat collector and heatsink are configured to be held at earth potential.

In an example, the heat collector and heatsink are configured to be held at earth potential when at least one of the upper terminal, and the lower terminal, the switching element.

In an example, the heat collector and heatsink are configured to be held at earth potential when the drive connection is held at a high voltage.

In an example, the heat collector and heatsink comprise a thermally conductive material.

In an example, the heat collector comprises aluminium and/or copper.

In an example, the heatsink comprises aluminium and/or copper.

In an example, the heat collector is adjacent to the lower terminal.

In an example, the material of the insulation housing has a high thermal conductivity.

An exemplar circuit breaker comprises:
- an upper terminal 1;
- a lower terminal 2;
- a switching element 3;
- an insulation housing 6; and
- a heatsink 7, 8.

The upper terminal is electrically connected to a fixed contact of the switching element. The lower terminal is electrically connected to a moveable contact of the switching element. The insulation housing surrounds at least part of the upper terminal, at least part of the lower terminal, and at least part of the switching element. A first part 7 of the heatsink is embedded within the insulation housing. The first part of the heatsink is separated from the at least part of the upper terminal, the at least part of the lower terminal, and the at least part of the switching element by material of the insulation housing. A second part 8 of the heatsink extends outwards from the circuit breaker and is not covered by material of the insulation housing.

Thus, a first part of the heatsink is casted or molded into a an electrically insulating plastic or resin insulation housing, and is not connected to any parts of the circuit breaker that operate at high voltage. The heatsink has a second part that extends from the first part and that sits outside the insulation hosing and heat is effectively extracted from the circuit breaker. As the heatsink is not raised to high voltages, but can remain at earth potential, the heatsink can be positioned relatively close to surfaces of s switchgear at earth potential without risk of electrical breakdown. This leads to space savings and less restrictive design requirments for the heatsink that would otherwise need to have specially designed fins/vanes to mitigate breakdown.

In an example, the switching element is a vacuum interrupter.

In an example, the second part of the heatsink comprises a plurality of fins or vanes.

In an example, the circuit breaker comprises a drive connection 5, and the drive connection is mechanically connected to the moveable contact of the switching element.

In an example, the insulation housing surrounds at least part of the drive connection.

In an example, the heat collector is separated from at least part of the drive connection by material of the insulation housing.

In an example, the heatsink is electrically insulated from the upper terminal, the lower terminal, and the switching element.

In an example, the heatsink is electrically insulated from the drive connection.

In an example, the heatsink is configured to be held at earth potential.

In an example, the heatsink is configured to be held at earth potential when at least one of the upper terminal, the lower terminal, and the switching element are held at a high voltage.

In an example, the heatsink is configured to be held at earth potential when the drive connection is held at a high voltage.

In an example, the heatsink comprises a thermally conductive material.

In an example, the heatsink comprises aluminium and/or copper.

In an example, the heatsink is adjacent to the lower terminal.

In an example, the material of the insulation housing has a high thermal conductivity.

An exemplar a method of manufacturing a circuit breaker comprises:
- assembling an upper terminal 1, a lower terminal 2, and a switching element 3, wherein the upper terminal is electrically connected to a fixed contact of the switching element, and wherein the lower terminal is electrically connected to a moveable contact of the switching element;
- molding at least part of the upper terminal, at least part of the lower terminal, at least part of the switching element, and a heat collector 7 within an insulation housing 6, such that the heat collector is at least partially embedded within the insulation housing, wherein the heat collector is separated from the at least part of the upper terminal, the at least part of the lower terminal, and the at least part of the switching element by material of the insulation housing, and wherein at least a part of a surface of the heat collector facing outwards from the circuit breaker is not covered by material of the insulation housing; and
- connecting a heatsink 8 to the part of the surface of the heat collector facing outwards from the circuit breaker.

In an example, the switching element is a vacuum interrupter.

In an example, the method comprises mechanically connecting a drive connection 5 to the moveable contact of the switching element

In an example, the heatsink comprises a plurality of fins or vanes.

In an example, the heat collector and heatsink are electrically insulated from the upper terminal, the lower terminal, the switching element.

In an example, the insulation housing surrounds at least part of the *drive connection.*

In an example, the heat collector is separated from at least part of the drive connection by material of the insulation housing.

In an example, the heat collector and heatsink are electrically insulated from the drive connection.

In an example, the heat collector and heatsink are configured to be held at earth potential.

In an example, the heat collector and heatsink are configured to be held at earth potential when at least one of the upper terminal, the lower terminal, and the switching element are held at a high voltage.

In an example, the heat collector and heatsink are configured to be held at earth potential when the drive connection is held at a high voltage.

In an example, the heat collector and heatsink comprise a thermally conductive material.

In an example, the heat collector comprises aluminium and/or copper.

In an example, the heatsink comprises aluminium and/or copper.

In an example, the heat collector is adjacent to the lower terminal.

An exemplar method of manufacturing a circuit breaker comprises:
- assembling an upper terminal 1, a lower terminal 2, and a switching element 3, wherein the upper terminal is electrically connected to a fixed contact of the switching element, and wherein the lower terminal is electrically connected to a moveable contact of the switching element; and
- molding at least part of the upper terminal, at least part of the lower terminal, at least part of the switching element, and a heatsink 7, 8 within an insulation housing 6, such that a first part 7 of the heatsink is embedded within the insulation housing, wherein the first part of the heatsink is separated from the at least part of the upper terminal, the at least part of the lower terminal, and the at least part of the switching element by material of the insulation housing, and wherein a second part 8 of the heatsink extends outwards from the circuit breaker and is not covered by material of the insulation housing.

In an example, the switching element is a vacuum interrupter.

In an example, the method comprises mechanically connecting a drive connection 5 to the moveable contact of the switching element.

In an example, the second part of the heatsink comprises a plurality of fins or vanes.

In an example, the heatsink is electrically insulated from the upper terminal, the lower terminal, the switching element.

In an example, the insulation housing surrounds at least part of the drive connection.

In an example, the heatsink is separated from at least part of the drive connection by material of the insulation housing.

In an example, the heatsink is electrically insulated from the drive connection.

In an example, the heatsink is configured to be held at earth potential.

In an example, the heatsink is configured to be held at earth potential when at least one of the upper terminal, the lower terminal, and the switching element are held at a high voltage.

In an example, the heatsink is configured to be held at earth potential when the drive connection is held at a high voltage.

In an example, the heatsink comprises a thermally conductive material.

In an example, the heatsink comprises aluminium and/or copper.

In an example, the heatsink is adjacent to the lower terminal.

In an example, the material of the insulation housing has a high thermal conductivity.

In a fifth aspect, there is provided a switchgear comprising a circuit breaker according to the fist aspect and/or a circuit breaker according to the second aspect.

It is to be noted that the new development has been described above with respect to those features necessary for understanding the new development. A real circuit breaker has further features as would be understood by the skilled person, such as bolts 9 for mounting the circuit breaker to a circuit breaker housing 10.

The new development is described in further specific detail, where reference is made to Figs. 1-2.

The new development came about as a consequence of customers wanting circuit breakers for medium voltage switchgears that are able to deal with higher currents. For such higher currents, Joule heating increases leading to the generation of much higher thermal loads. There are however temperature limits for the switchgear and all the components inside, which requires further heatsinks and/or heatsinks of increased size. But as heatsinks operate at high potential they must be kept clear from parts of the switchgear at earth potential, or electrical discharges can occur. Thus, the new development was to enable the heat sink to operate to extract heat from the circuit breaker, but be electrically separated from high voltage parts and be able to be held at earth potential.

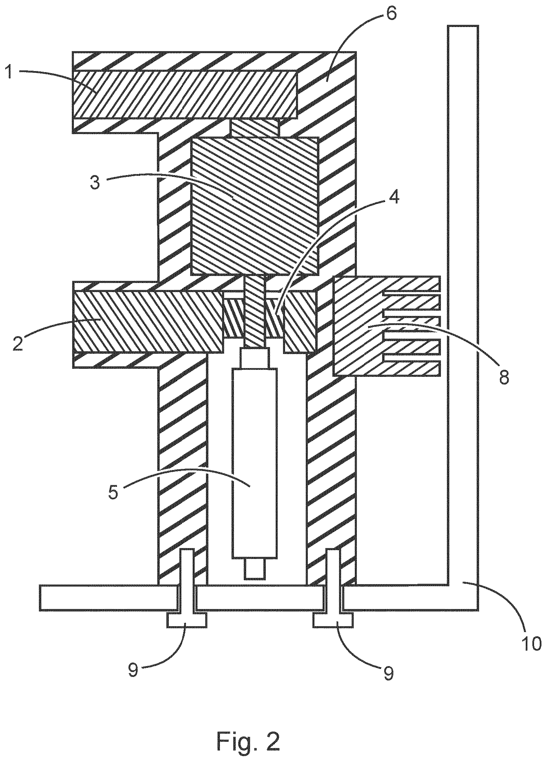

To achieve this a heat collector is cast or moulded inside the insulation housing of the pole, where it is possible to cast/mould the heat collector with the mould that was previously used with only some small adjustments. After moulding, a heatsink can be screwed onto a contact surface of the heat collector outside the pole. The embedded heat collector collects the thermal heat, generated as a consequence of joule heating in the current path, from the casted insulating material between the current path and the heat collector, that has a large surface area, and conducts this heat to the heatsink outside of the insulation housing. This is shown in Fig. 1. The heat collector and heatsink can however be combined as one part. This is shown in Fig. 2.

The advantages are then that the heat collector and heatsink, or the single piece heatsink, can be at earth potential, and can therefore be positioned directly next to metal parts of the circuit breaker or switchgear that are at earth potential, without any risk of breakdown, whereas previously the parts of the heatsink that would be at high potential would have to be kept distant from these earthed metal parts. Also, as the relevant parts are cast/moulded into the insulation housing, no additional insulating layer with high thermal conductivity is required.

Thus, in summary the new development is:
- Heat collector/Part of heatsink is embedded in an insulating material (in this case Epoxy)
- Heat collector/Heatsink is on earth potential and has no direct connection to parts on potential
- Material from Heat collector/Heatsink is a conductive metal with a high thermal conductivity like aluminium or copper

### Reference numerals

- 1: Upper terminal
- 2: Lower terminal
- 3: Switching element (E.g. Vacuum interrupter)
- 4: Movable contact
- 5: Drive connection
- 6: Insulation housing
- 7: Heat collector or first part of heatsink
- 8: Heatsink or second part of heatsink
- 9: Bolts
- 10: Circuit breaker housing

## Claims

1. A circuit breaker, comprising:
- an upper terminal (1);
- a lower terminal (2);
- a switching element (3);
- an insulation housing (6);
- a heat collector (7); and
- a heatsink (8);
wherein the upper terminal is electrically connected to a fixed contact of the switching element;
wherein the lower terminal is electrically connected to a moveable contact of the switching element;
wherein the insulation housing surrounds at least part of the upper terminal, at least part of the lower terminal, at least part of the switching element;
wherein the heat collector is at least partially embedded within the insulation housing, wherein the heat collector is separated from the at least part of the upper terminal, the at least part of the lower terminal, and the at least part of the switching element by material of the insulation housing;
wherein at least a part of a surface of the heat collector facing outwards from the circuit breaker is not covered by material of the insulation housing; and
wherein the heatsink is connected to the part of the surface of the heat collector facing outwards from the circuit breaker.

2. Circuit breaker according to claim 1, wherein the heat collector and heatsink are electrically insulated from the upper terminal, the lower terminal, and the switching element.

3. Circuit breaker according to any of claims 1-2, wherein the heat collector and heatsink are configured to be held at earth potential.

4. Circuit breaker according to claim 3, wherein the heat collector and heatsink are configured to be held at earth potential when at least one of the upper terminal, and the lower terminal, the switching element.

5. Circuit breaker according to any of claims 1-4, wherein the heat collector and heatsink comprise a thermally conductive material.

6. Circuit breaker according to any of claims 1-5, wherein the heat collector is adjacent to the lower terminal.

7. A circuit breaker, comprising:
- an upper terminal (1);
- a lower terminal (2);
- a switching element (3);
- an insulation housing (6); and
- a heatsink (7, 8);
wherein the upper terminal is electrically connected to a fixed contact of the switching element;
wherein the lower terminal is electrically connected to a moveable contact of the switching element;
wherein the insulation housing surrounds at least part of the upper terminal, at least part of the lower terminal, and at least part of the switching element;
wherein a first part (7) of the heatsink is embedded within the insulation housing, wherein the first part of the heatsink is separated from the at least part of the upper terminal, the at least part of the lower terminal, and the at least part of the switching element by material of the insulation housing; and
wherein a second part (8) of the heatsink extends outwards from the circuit breaker and is not covered by material of the insulation housing.

8. Circuit breaker according to claim 7, wherein the heatsink is electrically insulated from the upper terminal, the lower terminal, and the switching element.

9. Circuit breaker according to any of claims 7-8, wherein the heatsink is configured to be held at earth potential.

10. Circuit breaker according to claim 9, wherein the heatsink is configured to be held at earth potential when at least one of the upper terminal, the lower terminal, and the switching element are held at a high voltage.

11. Circuit breaker according to any of claims 7-10, wherein the heatsink comprises a thermally conductive material.

12. Circuit breaker according to any of claims 7-11, wherein the heatsink is adjacent to the lower terminal.

13. A method of manufacturing a circuit breaker, comprising:
- assembling an upper terminal (1), a lower terminal (2), and a switching element (3), wherein the upper terminal is electrically connected to a fixed contact of the switching element, and wherein the lower terminal is electrically connected to a moveable contact of the switching element;
- molding at least part of the upper terminal, at least part of the lower terminal, at least part of the switching element, and a heat collector (7) within an insulation housing (6), such that the heat collector is at least partially embedded within the insulation housing, wherein the heat collector is separated from the at least part of the upper terminal, the at least part of the lower terminal, and the at least part of the switching element by material of the insulation housing, and wherein at least a part of a surface of the heat collector facing outwards from the circuit breaker is not covered by material of the insulation housing; and
- connecting a heatsink (8) to the part of the surface of the heat collector facing outwards from the circuit breaker.

14. A method of manufacturing a circuit breaker, comprising:
- assembling an upper terminal (1), a lower terminal (2), and a switching element (3), wherein the upper terminal is electrically connected to a fixed contact of the switching element, and wherein the lower terminal is electrically connected to a moveable contact of the switching element; and
- molding at least part of the upper terminal, at least part of the lower terminal, at least part of the switching element, and a heatsink (7, 8) within an insulation housing (6), such that a first part (7) of the heatsink is embedded within the insulation housing, wherein the first part of the heatsink is separated from the at least part of the upper terminal, the at least part of the lower terminal, and the at least part of the switching element by material of the insulation housing, and wherein a second part (8) of the heatsink extends outwards from the circuit breaker and is not covered by material of the insulation housing.

15. A switchgear comprising a circuit breaker according to any of claims 1-6 and/or a circuit breaker according to any of claims 7-12.
